# EUROPEAN PATENT SPECIFICATION

(11) **EP 0 783 203 B1**
(45) Date of publication and mention of the grant of the patent: **11.12.2002**
(21) Application number: 96918870.5
(22) Date of filing: 21.06.1996
(51) Int. Cl.: H02M 7/538, H03K 17/0814, H02M 7/523

(54) **BRIDGE POWER CONVERTER**
LEISTUNGSWANDLER VOM BRÜCKENTYP
CONVERTISSEUR DE PUISSANCE EN PONT

(30) Priority: 23.06.1995 JP 15814295
(43) Date of publication of application: 09.07.1997
(73) Proprietor: KABUSHIKI KAISHA YASKAWA DENKI, Kitakyushu-Shi Fukuoka 806 (JP)
(72) Inventor: KUME, Tsuneo Kabushiki Kaisha Yaskawa Denki, Kitakyushu-shi Fukuoka 806 (JP); SAWA, Toshihiro Kabushiki Kaisha Yaskawa Denki, Kitakyushu-shi Fukuoka 806 (JP); SONODA, Sumitoshi Kabushiki Kaisha Yaskawa Denki, Kitakyushu-shi Fukuoka 806 (JP); YAMADA, Kenji Kabushiki Kaisha Yaskawa Denki, Kitakyushu-shi Fukuoka 806 (JP)
(74) Representative: Brown, Kenneth Richard
(86) International application number: PCT/JP96/01719
(87) International publication number: WO 97/001214

(56) References cited:
- EP-A- 0 419 230
- WO-A-84/00858
- DE-A- 4 127 706
- DE-A- 4 205 599
- JP-A- 3 107 328
- JP-A- 6 086 562
- US-A- 4 914 540
- MATSUO ET AL: "analysis of the improved soft-comutated pwm inverter by using an ac current transformer" PROCEEDINGS OF THE ANNUAL POWER ELECTRONICS SPECIALISTS CONFERENCE, vol. 1, 20 - 24 June 1994, TAIPEI,TAIWAN, pages 719-726, XP000492087
- GREEN ET AL: "A RECONSIDERATION OF THE DESIGN OF THE MODIFIED MCMURRAY INVERTER CIRCUIT" IEEE TRANSACTIONS ON INDUSTRY APPLICATIONS, vol. 1a, no. 018, 3 April 1982, NEW-YORK, pages 152-162, XP002064670
- THIYAGARAJAH: "a high switching frequency igbt pwm rectifier/inverter system for ac motor drives operating from single phase supply" IEEE TRANSACTIONS ON POWER ELECTRONICS, vol. 6, no. 4, October 1991, NEW-YORK, pages 576-584, XP000248870
- HARADA ET AL: "switched snubber for high frequency switching" 21ST ANNUAL IEEE POWER ELECTRONICS SPECIALISTS CONFERENCE, 11 - 14 June 1990, TEXAS, pages 101-108, XP000173916

## Description

### Field of the Invention

The present invention relates to bridge-type power converters in which one end of a series connection of two semiconductor switching elements each having a parallel diode is connected to the positive side of a d.c. bus while the other end is connected to the negative side.

### Background Art

In bridge-type power converters such as power inverters, the voltage of a d.c. voltage bus is switched by switching elements to provide an a-c output so that the voltage can change sharply. In order to reduce the switching loss, current ripples, and noise, the speed characteristic of elements has been improved, and the voltage change rate has increased. This raises the following problems.
(1) The abrupt voltage change against the ground produces electromagnetic waves, which interfere with other electronic equipment.
(2) Leak current goes to cables and electric motor windings via parasitic capacity.
(3) If a cable is long, there is a distributed constant circuit, forming a stable wave, and a voltage surge is applied to the electric motor.
(4) The high voltage change rate makes uneven a voltage distribution in the motor windings, applying a high voltage to a portion of the windings, causing insulation deterioration.

As a countermeasure, it is possible to provide a gradient to a driving signal for the gate or base of a main semiconductor element to reduce the switching speed. However, this method increases the switching loss.

As another measure an L-C resonance circuit is provided in the d.c. bus to block the d-c voltage so that the inverter bridge operates in the zero voltage period to avoid the sharp voltage change (see PCT patent application PCT/US87/02489). By this method, however, it is impossible to control continuously the time length of an output voltage.

As still another measure, a filter is provided between the inverter and the electric motor. However, if an L-C filter is used, the resistor for damping the continuing oscillation makes a loss. Also, it is necessary to determine a filter constant for individual motors.

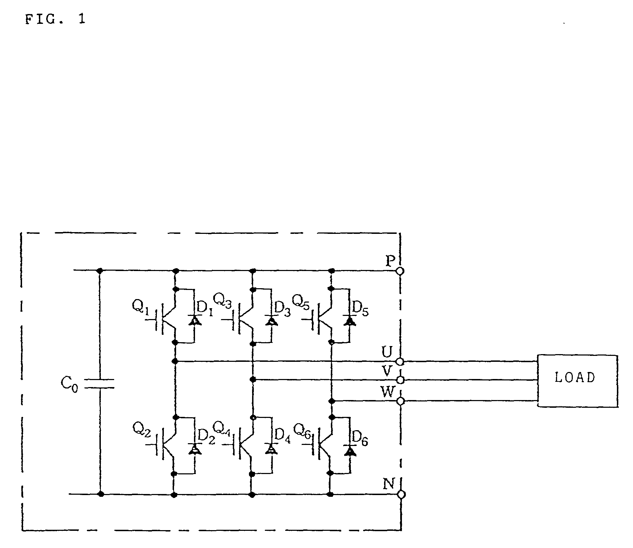

Fig. 1 shows a three-phase voltage inverter main circuit. The bridge circuit is composed of six switching elements Q₁ - Q₆ and six free wheel diodes D₁-D₆. The characteristics of the switching elements Q₁-Q₆ determine the on/off switching speed. The voltage at the output terminal is switched in very short time periods, raising the aforementioned problem.

DE 4205599 discloses a form of half-bridge welding inverter having two switching elements with parallel connected, reverse-biased diodes, connected in series across a d.c. power supply. A transformer primary is connected between the centre point of the switching elements and the centre point of the two capacitors also connected across the d.c. power supply.

In Proceedings of the Annual Power Electronics Specialists Conference, vol. 1, 20-24.6.1994, MATSUO et al.: "Analysis of the improved soft-commutated pwm inverter by using an a.c. current transformer" is disclosed a soft-commutation PWM technique of operating a d.c. - a.c. inverter; the inverter is of a half-bridge type, and power loss caused by circulating current is reduced by using an a.c. current transformer and an additional resonant capacitor.

EP 419230 discloses a power converter in which snubber circuits are connected across each of a pair of series connected power semiconductor switching elements. Each snubber circuit includes a snubber capacitor and a voltage-regulator diode arranged in forward direction with respect to the power supply.

### Disclosure of the Invention

It is an object of the invention to provide a bridge-type power converter which is able to reduce the voltage change rate at switching times of the voltage applied to an electric motor which is driven by the bridge-type power converter.

According to the invention there is provided a bridge-type power converter wherein, in each phase, a series connection of two semiconductor switching elements each having a backward parallel diode, one end of which is connected to a positive side of a d.c. bus and the other to a negative side of the d.c. bus, comprising: an inductor connected between a connection point of said two switching elements and an output terminal; capacitors connected between said output terminal and the positive or negative side of said d.c. bus for changing an output voltage along a curve determined by a phenomenon of resonance with said inductor when said semi-conductor switching elements operate, causing abrupt changes of a voltage at said connection point; and diodes for changing a current path so as to stop said resonance; characterised in that said diodes are arranged to change said current path at a time when said resonance goes approximately one quarter of period of the output voltage; and in that there is provided a constant voltage circuit for absorbing energy stored in said inductor during said resonance, said circuit comprising transistors arranged to provide a reverse conduction characteristic.

In a described embodiment, said constant voltage circuit connected to said positive and negative sides of said d.c. bus in each phase of the converter includes diodes forming a high-voltage or low-voltage priority circuit and diodes forming a backward current path, respectively.

In another embodiment, the converter further comprises a bridge-type power converter, which further comprises a chopper circuit for controlling voltages across capacitors which absorb energy stored in said inductor during resonance and returning absorbed energy to said d.c. bus.

The bridge-type power converter may further comprise an a.c. terminal connected to an a.c. power source so that the converter performs an a.c. - to d.c. power conversion.

The converter may further comprise a unit formed by additional connections between the power converter and an electric motor or a power source.

When the voltage of the output terminal is changed abruptly by switching of the bridge-type power converter, the voltage of the electric motor changes along a cosine curve by resonance and when the motor voltage reaches a certain level, the diodes and the constant voltage circuit provide a clamp function so as to absorb excessive energy. This controls the change rate of the voltage applied to the electric motor and the generation of excessive oscillations.

As has been described above, the change rate of the voltage reduced according to the invention produces the following advantages:
(1) There is less electromagnetic interference.
(2) There is less leak current.
(3) There are fewer standing waves and no or few voltage surges to the electric motor.
   Cables can be considered as an L-C distributed circuit so that when the output voltage of an inverter changes abruptly, a progressive wave goes to the electric motor. The impedance of a motor is much greater than that of a cable so that the impedance of a point between the cable and the motor can be considered to be open. Consequently, a reflected wave is generated at the motor terminal, forming a standing wave by combination of the progressive and reflected waves. Consequently, the motor terminal voltage goes up and can reach twice the output voltage of the inverter. When the change rate dv/dt of the inverter voltage is reduced, the above phenomenon is controlled so that there is hardly any voltage surge.
(4) The voltages of motor windings are balanced, making the life of the insulation longer.

### Brief Description of the Drawings

Fig. 1 is a schematic diagram of a three-phase voltage inverter main circuit;
Fig. 2 is a circuit diagram of a single phase of a bridge-type power converter forming the basis for an embodiment of the invention;
Fig. 3 is a chart showing output voltages of the circuit in Fig.2 ;
Fig. 4 is a three-phase circuit diagram developed from the circuit of Fig.2;
Fig. 5 is a circuit diagram of a three-phase bridge-type power converter having a common constant voltage circuit; and
Fig. 6 is a circuit diagram of a three-phase bridge-type power converter having a power regenerative function.

### Description of the preferred Embodiment

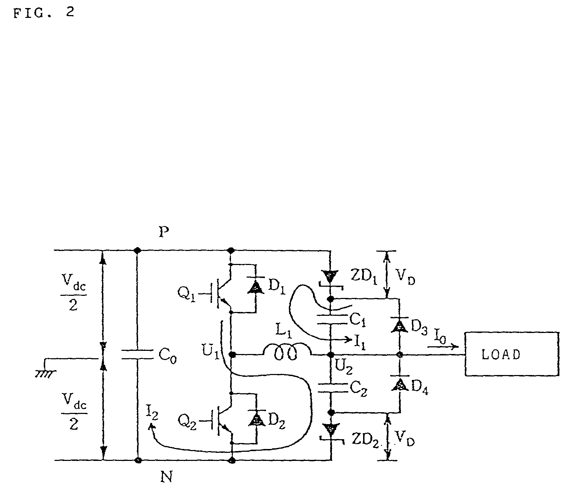

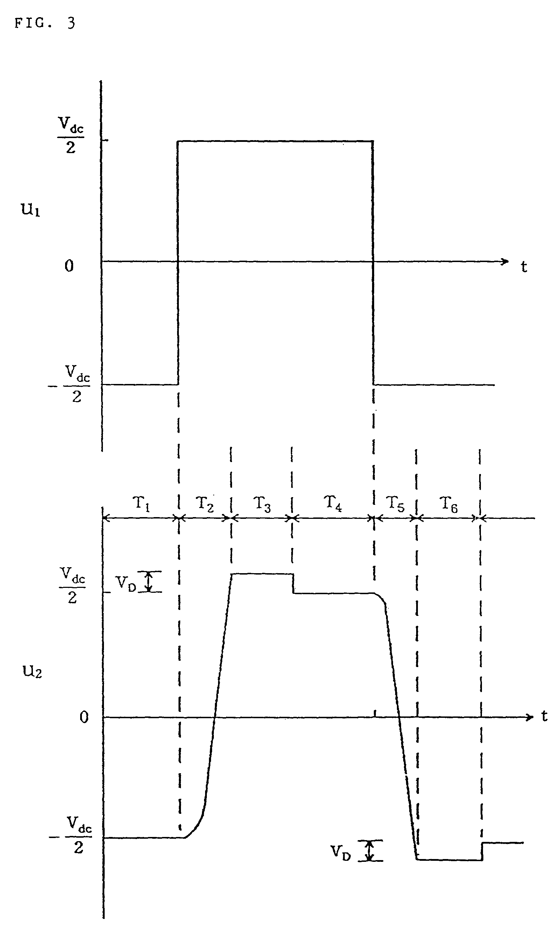

Fig. 2 shows a single phase of a bridge-type power converter upon which this invention is based. Fig. 3 shows input and output voltage waveforms of the power converter.

This bridge-type power converter includes a capacitor C₀, two switching elements Q₁ an Q₂, two diodes D₁ and D₂, a coil L₁, two capacitors C₁ and C₂, two diodes D₃ and D₄, and two constant voltage diodes (Zener diodes) ZD₁, and ZD₂.

It is assumed that all elements and parts have ideal characteristics. Also, it is assumed that the current through a load or electric motor is constant in short time periods before and after switching and that its direction is expressed by an arrow I₀ (for symmetry of the circuit, the opposite direction is omitted).

As Fig. 3 shows, the operation mode can be divided into six time sections T₁-T₆.

In the time section T₁, the transistor Q₁ is off and stable, and the current flows to the load from the N bus via the diode D₂ and the coil L₁. The transistor Q₂ is on but the current direction is opposite so that the diode D₂ is on. At this point, the capacitor C₁ is charged to a voltage (Vdc + v_{D}) where V_{D} is the voltage of the constant voltage diodes ZD₁ an ZD₂ and the voltage across the capacitor C₂ is 0.

When the transistors Q₂ and Q₁ are turned off and on, respectively, the time section T₂ begins. That is, when the transistors Q₂ and Q₁ are turned off and on, respectively, the capacitor C₁ is discharged and the capacitor C₂ is charged. At this point, the load current changes from the diode D₂ to the transistor Q₁ so that the currents I₁ and I₂ flow as shown in Fig. 2, establishing two resonance circuits simultaneously. One circuit is C₁ -> ZD₁ -> Q₁ -> U₁ -> L₁ -> U₂ -> C₁ and the other is C₀ -> P -> Q₁ -> U₁ -> L₁ -> U₂ -> C₂ -> ZD₂ -> N -> C₀. These resonance currents are superimposed so as to increase the current of the transistor Q₁ and the coil L₁. Consequently, the voltage across the capacitor C₁ decreases along a cosine curve while the voltage across the capacitor C₂ increases along a cosine curve. The potential at the output terminals U₂ increases along with the increasing voltage. When the potential of the output terminal U₂ reaches a voltage (Vdc/2 + V_{D}), the voltage across the capacitor C₁ becomes zero, bringing the time section T₂ to an end.

Since the coil L₁ stores excessive energy generated by the resonance when the voltage across the capacitor C₁ is zero, a circular current L₁ -> U₂ -> D₃ -> ZD₁ -> P -> Q₁ -> U₁ continues to flow in the time section T₃, and the magnitude decreases at a rate of V_{D}/L₁. During this time U₂ is clamped to a potential (Vdc/2 + V_{D}). When the circular current becomes zero, the time section ends and U₂ has a potential equal to the potential of P.

The state of the time section T₄ is stable when the transistor Q₁ is turned on. At this point, the voltages across the capasitors C₁ and C₂ are O and (Vdc + V_{D}), respectively.

When the transistors Q₁ and Q₂ are turned off and on, respectively, the time section T₅ starts. The load current changes from the transistor Q₁ to the diode D₂, establishing two resonance circuits simultaneously. One is C₂ -> U₂ -> L₁ -> U₁ -> D₂ (or Q₂) -> N -> ZD₂ and the other is C₀ -> P -> ZD₁ -> C₁ -> U₂ -> L₁ -> U₁ -> D₂ (or Q₂) -> N -> C₀. The resonance currents are superimposed in such a direction (opposite to the output current I₀) as to offset the current of the coil L₁. Consequently, the voltage of the capacitor C₂ decreases along a cosine curve while the voltage of the capacitor C₁ increases along a cosine curve. The potential at the output terminal U₂ decreases along with the decrease. When the level of the output terminal U₂ reaches -(Vdc/2 + V_{D}), the voltage across the capacitor C₂ becomes zero, bringing the time section T₅ to an end.

When the voltage of the capacitor C₂ becomes zero, the coil L₁ stores excessive energy by the resonance so that a circular current continues to flow as L₁ -> U₁ -> D₂ (or Q₂) -> N -> ZD₂ -> D₄ -> U₂ in the section T₆, and the magnitude decreases at a rate of V_{D}/L₁ (the current of L₁ increases toward I₀). During this period, U₂ is clamped to a potential -(Vdc/2 + V_{D}). When the circular current becomes zero, the section ends, bringing the potential of the output terminal U₂ equal to the potential of N. When the section T₆ ends, the potential returns to the same stable state as the section T₁.

In Fig. 2, the constant voltage diodes ZD₁ and ZD₂ absorb the resonance energy. In practice, a circuit is used in which parallel diodes provide a reverse conduction are connected backwardly to a shunt regulator in which transistors characteristic and are used to keep the voltage constant.

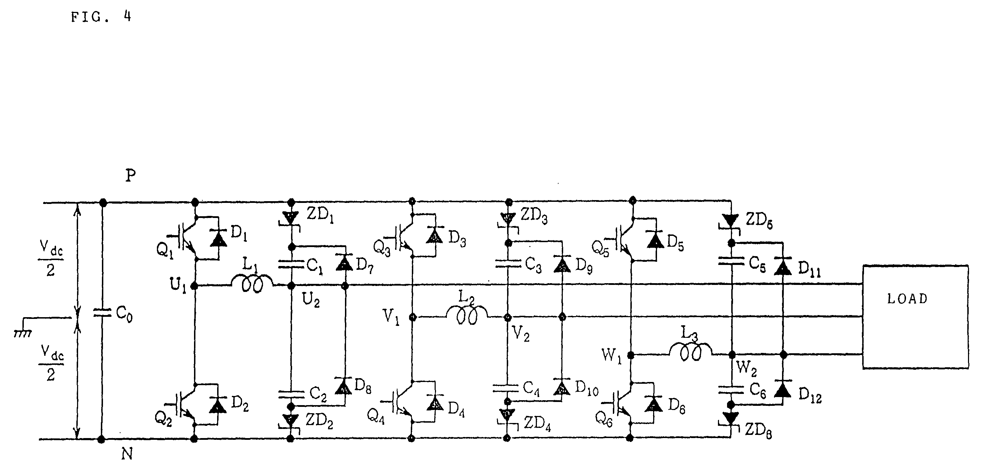

Fig. 4 is a circuit diagram of a bridge-type power converter developed from the circuit of Fig. 2. The circuit of a U phase is the same as that of Fig. 2.

Two switching transistors Q₃ and Q₄, two diodes D₃ and D₄, a coil L₂, two capacitors C₃ and C₄, two diodes D₉ and D₁₀, and two constant voltage diode ZD₃ and ZD₄ form a V-phase circuit while two switching transistors Q₅ and Q₆, two diodes D₅ and D₆, a coil L₃, capacitors C₅ and C₆, two diodes D₁₁ and D₁₂, and two constant voltage diode ZD₅ and ZD₆ form a W-phase circuit.

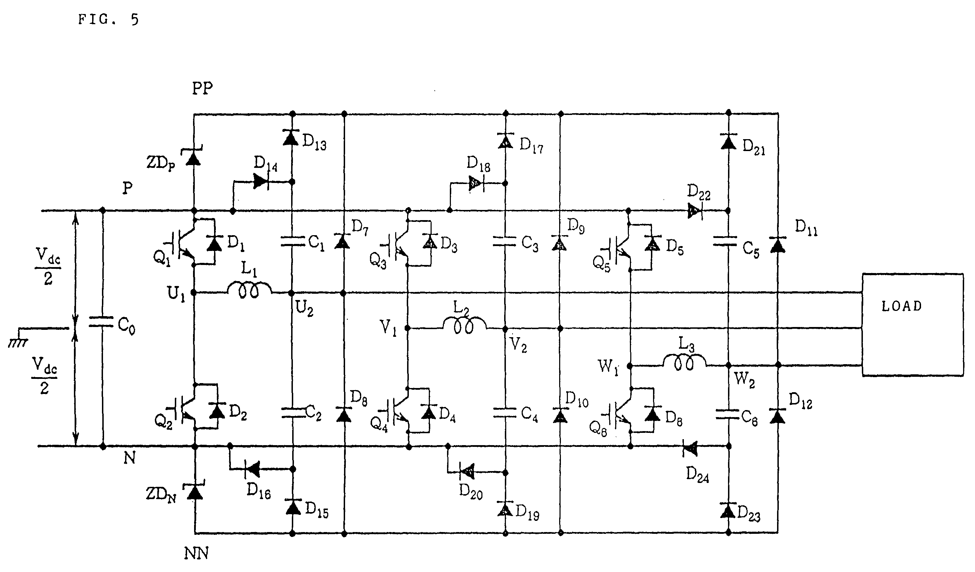

In Fig. 5, the constant voltage diodes ZD₁, ZD₃, ZD₅ connected to the positive side of d.c. bus P in Fig. 4 are replaced by a common voltage diode ZDₚ by means of a high-voltage priority circuit consisting of diodes D₁₃, D₁₇, and D₂₁ and a back current circuit consisting of D₁₄, D₁₈, and D₂₂ while the constant voltage diodes ZD₂, ZD₄, and ZD₆ connected to the negative side d.c. bus N are replaced by a common voltage diode ZD_{N} by means of a low-voltage priority circuit consisting of diodes D₁₅, D₁₉ an D₂₃ and back current circuit consisting of diodes D₁₆, D₂₀, and D₂₄.

In practice, snubber energy processors or circuits equilalent to ZD_{P} and ZD_{N} for processing commutation energy in current inverters are made as follows.
(1) Shunt Regulators: Transistors are used to keep the voltage constant.
(2) Combination of Capacitor and Chopper: The capacitor absorbs pulses and energy is returned to P/N bus by a chopper-so as to keep the voltage constant.

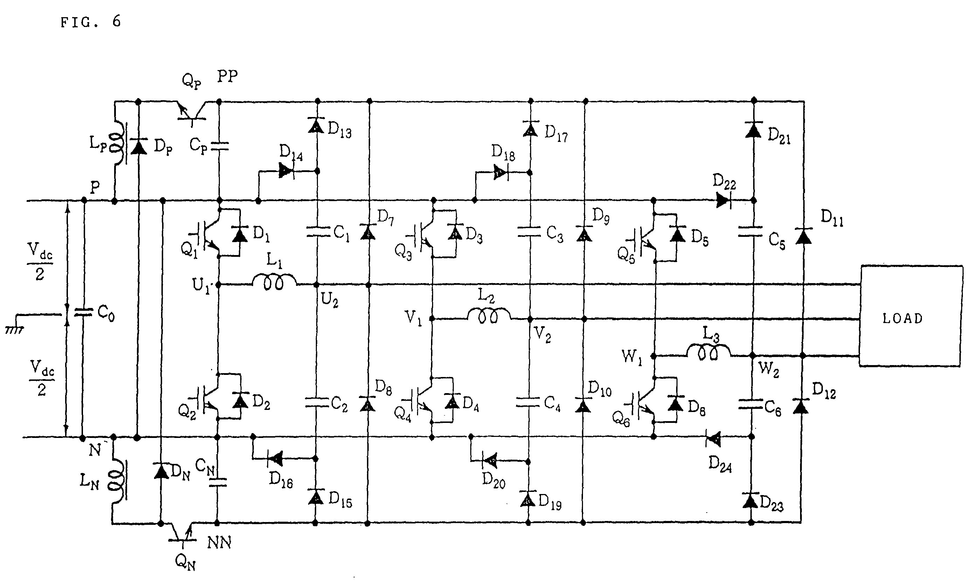

Fig. 6 shows a circuit in which the common constant voltage diodes ZD_{P} and ZD_{N} of the inverter-type power converter in Fig. 2 are replaced by capacitors C_{P} and C_{N}, diodes D_{P} and D_{N}, and transistors Q_{P} an Q_{N}, and coils L_{P} and L_{N} so as to return by choppers excessive energy generated by resonance to the d.c. bus. That is, the energy absorbed by the capacitors C_{P} and C_{N} is returned to the respective d.c. circuits by a chopper consisting of the transistor Q_{P}, the diode D_{P}, and the coil L_{P} and a chopper consisting of the transistor Q_{N}, the diode D_{N}, and the coil L_{N}.

As has been describe above, the bridge-type power converter is able to convert d.c. to a.c. to drive an a.c. load and a.c. to d.c. when the a.c. terminals are connected to an a.c. power source and control the current waveform of the power source. The device according to the invention is able to reduce an impact which sharp voltage changes have on a load.

## Claims

1. A bridge-type power converter wherein, in each phase, a series connection of two semiconductor switching elements (Q₁/Q₂, Q₃/Q₄, Q₅/Q₆) each having a backward parallel diode (D₁/D₂, D₃/D₄, D₅/D₆), one end of which is connected to a positive side (P) of a d.c. bus and the other to a negative side (N) of the d.c. bus, comprising:
an inductor (L₁, L₂, L₃) connected between a connection point (U₁, V₁, W₁) of said two switching elements and an output terminal (U₂, V₂, W₂);
capacitors (C₁/C₂, C₃/C₄, C₅/C₆) connected between said output terminal and the positive or negative side of said d.c. bus for changing an output voltage along a curve determined by a phenomenon of resonance with said inductor when said semi-conductor switching elements operate, causing abrupt changes of a voltage at said connection point; and
diodes (D₇/D₈, D₉/D₁₀, D₁₁/D₁₂) for changing a current path so as to stop said resonance; **characterised in that** said diodes (D₇/D₈, D₉/D₁₀, D₁₁/D₁₂) are connected in parallel to the capacitors (C₁/C₂, C₃/C₄, C₅/C₆) and are arranged to change said current path at a time when said resonance goes approximately one quarter of period of the output voltage; and **in that** there is provided a constant voltage circuit for absorbing energy stored in said inductor during said resonance, said circuit comprising transistors arranged to provide a reverse conduction characteristic.

2. A bridge-type power converter according to claim 1 in the form of a multiple phase bridge-type power converter, wherein said constant voltage circuit connected to said positive and negative sides of said d.c. bus in each phase of the converter includes diodes (D₁₃/D₁₇/D₂₁, D₁₅/D₁₉/D₂₃) forming a high-voltage or low-voltage priority circuit and diodes (D₁₄/D₁₈/D₂₂, D₁₆/D₂₀/D₂₄) forming a backward current path, respectively.

3. A bridge-type power converter according to claim 2, which further comprises a chopper circuit (Qₚ/Dₚ/Lₚ, Q_{N}/D_{N}/L_{N}) for controlling voltages across capacitors (Cₚ, C_{N}) which absorb energy stored in said inductor during resonance and returning absorbed energy to said d.c. bus.

4. A bridge-type power converter according to any one of claims 1 to 3, which further comprises a.c. terminals connected to an a.c. power source so that the converter performs an a.c. - to - d.c. power conversion.

5. A bridge-type power converter according to claim 1, which further comprises a unit formed by additional connections between said power converter and an electric motor or a power source.

## Patentansprüche

1. Leistungswandler vom Brückentyp, wobei in jeder Phase, eine Reihenschaltung von zwei Halbleiter-Schaltungselementen (Q₁/Q₂, Q₃/Q₄, Q₅/Q₆), die jeweils eine parallele Rückwärtsdiode (D₁/D₂, D₃/D₄, D₅/D₆) aufweisen, ein Ende derselben mit einer positiven Seite (P) eines DC-Busses und das andere Ende mit einer negativen Seite (N) des DC-Busses verbunden ist, mit:
einem Induktor (L₁, L₂, L₃), der zwischen einem Verbindungspunkt (U₁, V₁, W₁) der beiden Schaltungselemente und einem Ausgangsanschluss (U₂, V₂, W₂) verbunden ist;
Kondensatoren (C₁/C₂, C₃/C₄, C₅/C₆), die zwischen dem Ausgangsanschluss und der positiven oder negativen Seite des DC-Busses zum Ändern einer Ausgangsspannung entlang einer Kurve verbunden sind, die durch ein Resonanzphänomen mit dem Induktor bestimmt wird, wenn die Halbleiter-Schaltungselemente arbeiten, das plötzliche Änderungen einer Spannung an dem Verbindungspunkt verursacht; und
Dioden (D₇/D₈, D₉/D₁₀, D₁₁/D₁₂) zum Ändern eines Strompfades, um die Resonanz zu stoppen; **dadurch gekennzeichnet, dass** die Dioden (D₇/D₈, D₉/D₁₀, D₁₁/D₁₂) mit den kondensatoren (C₁/C₂, C₃/C₄, C₅/C₆) parallel geschaltet und angeordnet sind, um den Strompfad zu einer Zeit zu ändern, wenn die Resonanz ungefähr ein Viertel einer Periode der Ausgangsspannung geht; und dadurch, dass eine Konstantspannungsschaltung zum Absorbieren der in dem Induktor während der Resonanz gespeicherten Energie bereitgestellt wird, wobei die Schaltung Transistoren umfasst, die angeordnet sind, um eine Rückwärtsleitungseigenschaft bereitzustellen.

2. Leistungswandler vom Brückentyp gemäß Anspruch 1 in der Form eines Mehrphasen-Leistungswandlers vom Brückentyp, wobei die mit dem positiven und negativen Seiten des DC-Busses in jeder Phase des Wandlers verbundene Konstantspannungsschaltung Dioden (D₁₃/D₁₇/D₂₁, C₁₅/D₁₉/D₂₃), die eine Hochspannungs- oder Niederspannungs-Prioritätsschaltung bilden, bzw. Dioden (D₁₄/D₁₈/D₂₂, D₁₆/D₂₀/D₂₄), die einen Rückwärtsstrompfad bilden, aufweist.

3. Leistungswandler vom Brückentyp gemäß Anspruch 2, der ferner eine Zerhackerschaltung (Q_{P}/D_{P}/L_{P}, Q_{N}/D_{N}/L_{N}) zum Steuern von Spannungen über Kondensatoren (C_{P}, C_{N}), die in dem Induktor während der Resonanz gespeicherte Energie absorbieren, und Zurückgeben der absorbierten Energie an den DC-Bus umfasst.

4. Leistungswandler vom Brückentyp gemäß einem der vorhergehenden Ansprüche 1 bis 3, der ferner einen mit einer Wechselstromleistungsquelle verbundenen Wechselstromanschluss umfasst, so dass der Wandler eine Wechselstrom-Gleichstrom-Leistungsumwandlung durchführt.

5. Leistungswandler vom Brückentyp gemäß Anspruch 1, der ferner eine Einheit umfasst, die durch zusätzliche Verbindungen zwischen dem Leistungswandler und einem elektrischen Motor oder einer Leistungsquelle gebildet wird.

## Revendications

1. Convertisseur de puissance de type pont dans lequel, dans chaque phase, une connexion série de deux éléments de commutation à semiconducteur (Q₁/Q₂, Q₃/Q₄, Q₅/Q₆) comportant chacun une diode parallèle inverse (D₁/D₂, D₃/D₄, D₅/D₆), dont une extrémité est connectée à un côté positif (P) d'un bus à courant continu et l'autre à un côté négatif (N) du bus à courant continu, comprenant :
une bobine d'inductance (L₁, L₂, L₃) connectée entre un point de connexion (U₁, V₁, W₁) desdits deux éléments de commutation et une borne de sortie (U₂, V₂, W₂) ;
des condensateurs (C₁/C₂, C₃/C₄, C₅/C₆) connectés entre ladite borne de sortie et le côté positif ou négatif dudit bus à courant continu pour changer une tension de sortie le long d'une courbe déterminée par un phénomène de résonance avec ladite bobine d'inductance lorsque lesdits éléments de commutation à semiconducteur fonctionnent, provoquant des changements de tension brusques au niveau dudit point de connexion ; et
des diodes (D₇/D₈, D₉/D₁₀, D₁₁/D₁₂) pour modifier le trajet du courant afin d'arrêter ladite résonance, **caractérisé en ce que** lesdites diodes (D₇/D₈, D₉/D₁₀, D₁₁/D₁₂) sont montées en parallèle avec les condensateurs (C₁/C₂, C₃/C₄, C₅/C₆) et sont agencées de façon à changer ledit trajet du courant au moment où ladite résonance atteint à peu près un quart de la période de la tension de sortie, et **en ce qu'**il est prévu un circuit à tension constante pour absorber l'énergie emmagasinée dans ladite bobine d'inductance pendant ladite résonance, ledit circuit comprenant des transistors qui sont agencés de façon à donner une caractéristique de conduction dans le sens inverse.

2. Convertisseur de puissance de type pont selon la revendication 1 sous forme d'un convertisseur de puissance de type pont à plusieurs phases, dans lequel ledit circuit à tension constante connecté auxdits côtés positif et négatif dudit bus à courant continu dans chaque phase du convertisseur comprend des diodes (D₁₃/D₁₇/D₂₁, D₁₅/D₁₉/D₂₃) formant un circuit prioritaire à haute tension ou à basse tension et des diodes (D₁₄/D₁₈/D₂₂, D₁₆/D₂₀/D₂₄) formant un trajet de courant inverse, respectivement.

3. Convertisseur de puissance de type pont selon la revendication 2, qui comprend en outre un circuit de découpage (Qₚ/Dₚ/Lₚ, Q_{N}/D_{N}/L_{N}) pour commander les tensions aux bornes de condensateurs (Cₚ, C_{N}) qui absorbent l'énergie emmagasinée dans ladite bobine d'inductance pendant la résonance et renvoient l'énergie absorbée audit bus à courant continu.

4. Convertisseur de puissance de type pont selon l'une quelconque des revendications 1 à 3, qui comprend en outre des bornes à courant alternatif reliées à une source d'alimentation à courant alternatif de sorte que le convertisseur réalise une conversion de puissance alternatif-continu.

5. Convertisseur de puissance de type pont selon la revendication 1, qui comprend en outre une unité formée par des connexions supplémentaires entre ledit convertisseur de puissance et un moteur électrique ou une source de puissance.
